# EUROPEAN PATENT APPLICATION

(11) **EP 4 585 673 A1**
(43) Date of publication of application: **16.07.2025**
(21) Application number: 23926714.9
(22) Date of filing: 14.03.2023
(51) Int. Cl.: C11D 7/32, C11D 7/50, C11D 7/60, C23C 22/63, C23G 1/20, H01L 21/02

(54) **CLEANING LIQUID AFTER CHEMICAL MECHANICAL POLISHING FOR SEMICONDUCTOR CHIP, AND PREPARATION METHOD FOR CLEANING LIQUID AND USE OF CLEANING LIQUID**

(71) Applicant: Zhejiang Aufirst Materials Technology Co., Ltd, Quzhou, Zhejiang 324012 (CN)
(72) Inventor: HOU, Jun, Quzhou, Zhejiang 324012 (CN); SHEN, Haiyan, Quzhou, Zhejiang 324012 (CN); LV, Jing, Quzhou, Zhejiang 324012 (CN); REN, Haonan, Quzhou, Zhejiang 324012 (CN)
(74) Representative: Nederlandsch Octrooibureau
(86) International application number: PCT/CN2023/081190
(87) International publication number: WO 2024/187355

(57) **Abstract**

A post-chemical mechanical polishing cleaning solution of semiconductor chips, a preparation method and use thereof are provided. The post-chemical mechanical polishing cleaning solution of semiconductor chips includes, parts by mass: 5-20 parts of a strong base; 5-30 parts of a weak base; 0.5-3 parts of a cellulose derivative; 0.5-2 parts of a chitin derivative; 70-95 parts of ultrapure water. The cellulose derivative is one or more of 2,5-furandicarboxylic acid, levulinic acid, and 5-aminolevulinic acid. The chitin derivative is one or more of chitosan oligosaccharide, carboxymethyl chitosan, N-acetyl glucose, glucosamine, and carboxymethyl glucosamine.

## Description

### TECHNICAL FIELD

The present disclosure relates to a cleaning technology, and more particularly, to a post-chemical mechanical polishing cleaning solution of a semiconductor chip, and a preparation method and use thereof.

### BACKGROUND

At present, as feature size of semiconductor devices becomes smaller and smaller, copper has been widely used in internal interconnection lines of semiconductor devices in order to reduce interconnect delays. In a conventional multilayer copper interconnection process, it is required to conduct a chemical mechanical polishing (CMP) process to remove excess copper, after the electroplating of copper is completed. Many contaminants, such as particulate contaminants, exist on the surface of the wafer after the CMP proccess, which are derived from the polishing fluid, the polishing pad, or copper residue being polished. Among them, the particle contamination of Cu and CuO may cause a large impact on the chips, which may cause a line short circuit. In addition, Cu surface after the CMP process is oxidized to generate hydrophobic CuO, which is detrimental to subsequent cleaning. The main reason is that the surface of pure copper, which is hydrophilic, can be completely wetted by water to form a layer of water film, so that the surface of the wafer rotating at a high speed can be wetted by pure water in a next cleaning step, and when the cleaning brush is moved to abut against the wafer surface, the brush slides on the water film of the wafer surface, without being in direct contact with the wafer surface. The water film moves at a high speed on the wafer surface, and the particle contaminants on the surface of the wafer are removed by the friction force generated thereby. However, once the copper surface is oxidized to generate CuO, the copper surface becomes water repellent , and a water film cannot be formed. In this case, the brush are directly contacted with the wafer surface when cleaning, so that the particles adhered to the brush are transferred to adhere to the wafer surface, thereby causing secondary contamination.

Therefore, in order to completely remove the contaminant particles obtained in the CMP cleaning process, the wafer is generally placed in an acidic or alkaline cleaning solution in the related art to clean the contaminant particles, thereby achieving the purpose of cleaning the surface of the wafer. However, there are a number of disadvantages in the related art. It is known that chemically-mechanically polished Cu surface is usually covered by one or more oxide films, for example, the upmost CuO layer, the intermediate Cu₂O layer, and the substrate is Cu. Acidic post-CMP cleaning solutions can dissolve CuO and Cu₂O on the copper surface, and alkaline post-CMP cleaning solutions for semiconductor chips can selectively dissolve CuO, leaving Cu₂O to passivate the surface. Furthermore, the acidic cleaning solutions may cause severe damage for Cu, and thus they are less used at present.

After cleaning is completed, the next step is a film deposition process. However, the process is not performed immediately, and there is a waiting time (Q-time) after the cleaning process. The wafer is left in an O₂-containing environment during the waiting time, so that there is a risk of re-oxidation of Cu₂O on the wafer surface. The waiting time generally cannot exceed 4 hours, otherwise the wafer surface is re-oxidized to form a CuO film having a thickness exceeding a limit once more than 4 hours have passed. The CuO film has a poor conductivity, and may increase circuit impedance or break circuit paths between metal layers, or even cause failure of the wafer, thus affecting wafer yield.

Experiments show that the waiting time, as an important technical index, present between CMP for copper and the subsequent deposition process for barrier layer in the conventional method is proven to be closely related to time dependent dielectric breakdown (TDDB) of the semiconductor device. The TDDB, as a common means for measuring the reliability of a gate oxide layer of a metal-oxide-semiconductor field-effect transistor (MOSFET, abbreviated as MOS) device, specifically refers to the time required for breakdown of the gate oxide layer using a strong electric field, which is closely related to a breakdown voltage (V_{bd}). In actual production, the V_{bd} can be regarded as a parameter for fast detecting TDDB. When the waiting time is long, the generated CuO film will be thicker, the TDDB will be longer, the V_{bd} will be smaller, and the gate oxide layer of the MOS device will be less reliable. Therefore, in order to improve the reliability of the device, it is necessary to suppress re-oxidation rate of the cleaned surface and to lengthen the process window.

A second disadvantage in the prior art is that CuO films formed on the surface of the wafer during CMP process and generated in the subsequent waiting time make the surface of the wafer hydrophobic and unable to form a water film. In this case, the brush and the surface of the wafer are directly contacted during the cleaning process, so that the particles adhered to the brush are transferred to the surface of the wafer, thereby causing secondary contamination and increasing the difficulty of subsequent cleaning. Therefore, it is necessary to remove the CuO film to avoid secondary contamination of the wafer.

In summary, if the CuO can be removed as soon as possible after the CMP step for copper, and the oxidation rate of the cleaned surface within the waiting time can be delayed, the waiting time between the CMP for copper and the subsequent deposition step for the barrier layer can be prolonged, which can greatly facilitate the production and create favorable conditions for preventing V_{bd} from being reduced, thereby improving the reliability of the gate oxide layer of the MOS device.

CN103232885A discloses an emulsified oil for cooling copper rods during the production of copper bars for electromagnetic wires. The octylphenol polyoxyethylene ether can be used as a reducing agent to remove copper oxide, and sodium petroleum sulfonate acts as a metal corrosion inhibitor to prevent corrosion of copper.

CN1680626A discloses a post-chemical mechanical polishing cleaning solution of semiconductor chips, which includes various additives, such as an organic acid chelating agent, a preservative, a corrosion inhibitor, a surfactant, and the like, so as to remove surface impurities on a Si wafer by the combined action of various additives.

CN113151838A discloses a post-chemical mechanical polishing cleaning solution, which achieves high cleaning capacity, low material corrosion and good BTA removal effect by adding an antioxidant, a copper complex, a corrosion inhibitor, a chelating agent, and a surfactant. The corrosion inhibitor 2-mercaptobenzothiazole, heteropolycyclic copper complex, and the surfactant dodecylbenzenesulfonic acid are all petroleum-derived products.

In the above-mentioned patent applications, the post-metal polishing cleaning solutions needs to realize removal of particle and metal contamination and inhibition of metal corrosion, so a number of compounds need to be added. However, many of the additives are derived from petroleum. Petroleum is a non-renewable resource, and brings about the problems such as environmental pollution, climate warming and resource and energy crisis, which become the focus of the industry. At present, developing green energy is a top research priority.

### SUMMARY OF THE DISCLOSURE

In order to address the problems that the conventional acidic and alkaline cleaning solutions have unsatisfactory CuO cleaning and new CuO films are formed during a waiting time, the present disclosure provides a post-chemical mechanical polishing (post-CMP) cleaning solution of semiconductor chips, which can effectively remove CuO generated on a post-CMP surface of copper, and form a monomolecular adsorbent layer on the Cu surface, thereby effectively suppressing re-oxidation of the Cu surface within the waiting time, preventing the reduction of V_{bd} and improving the reliability of a gate oxide layer of a MOS device.

It is to be noted that in the present disclosure, unless otherwise specified, reference to the specific meaning of "including",and other similar meanings as defined and described in the context is intended to include an open meaning of "including" or "containing" meaning and other similar meanings, as well as a closed meaning generally represented by the phrase "consist of" and others.

In order to achieve the above objective, the present disclosure provides a post-chemical mechanical polishing cleaning solution of semiconductor chips, which includes, parts by mass:
5-20 parts of a strong base;
5-30 parts of a weak base;
0.5-3 parts of a cellulose derivative;
0.5-2 parts of a chitin derivative; and
70-95 parts of ultra-pure water.

Further, the strong base is one or more of an organic strong base and an inorganic strong base.

Further, the inorganic strong base is one or more of potassium hydroxide and cesium hydroxide.

Further, the organic strong base is a quaternary ammonium hydroxide.

Further, the quaternary ammonium hydroxide is one or more of tetramethyl ammonium hydroxide, tetraethyl ammonium hydroxide, tetrapropyl ammonium hydroxide, tetrabutyl ammonium hydroxide, dimethyldiethyl ammonium hydroxide, (2-hydroxyethyl)trimethyl ammonium hydroxide, and tris(2-hydroxyethyl)-methyl ammonium hydroxide.

Further, the quaternary ammonium hydroxide is preferably one or more of tetramethyl ammonium hydroxide, tetrabutyl ammonium hydroxide, and tris(2-hydroxyethyl)-methyl ammonium hydroxide.

Further, the strong base accounts for, parts by mass, 5-20 parts, for example, 5 parts, 10 parts, 15 parts or 20 parts.

Further, the strong base preferably accounts for 5 to 10 parts.

Further, the weak base is an organic alcohol amine.

Further, the organic alcohol amine is one or more of monoethanolamine, diethanolamine, triethanolamine, N-methyl ethanolamine, N,N-dimethyl ethanolamine, N-ethyl ethanolamine, N-phenyl ethanolamine, N-methyl diethanolamine, isopropanolamine, triisopropanolamine, and diglycolamine.

Further, the organic alcohol amine is preferably one or more of triethanolamine, diglycolamine, and N-methyl ethanolamine.

Further, the weak base accounts for, parts by mass, 5-30 parts, for example, 5 parts, 10 parts, 15 parts, 20 parts, 25 parts, or 30 parts.

Further, the weak base preferably accounts for 5-20 parts.

The cleaning solution according to the present disclosure provides an alkaline environment, which can improve electrostatic repulsion between particle contaminants and substrates, can completely remove contaminations from abrasive particles and metal particles, and prevent re-adsorption of particles. The cleaning solution according to the present disclosure improves the pH value and buffering performance of the system by mixing the strong base and the weak base.

Further, the cellulose derivative is obtained by degradation and conversion of cellulose, and the cellulose derivative is one or more of 2,5-furandicarboxylic acid, levulinic acid and 5-aminolevulinic acid.

Further, the cellulose derivative is preferably two of 2,5-furandicarboxylic acid, levulinic acid and 5-aminolevulinic acid.

Further, the cellulose derivative is preferably 2,5-furandicarboxylic acid and 5-aminolevulinic acid.

The cellulose derivative according to the present disclosure uses both 2,5-furandicarboxylic acid and 5-aminolevulinic acid, so that the corrosion by the carboxyl group and the chelation by the amino group can be used together to remove CuO more quickly.

Further, a mass ratio of 2,5-furandicarboxylic acid to 5-aminolevulinic acid is 4:1-1:4.

Further, the mass ratio of 2,5-furandicarboxylic acid to 5-aminolevulinic acid is preferably 2:1-1:4.

Further, the mass ratio of 2,5-furandicarboxylic acid to 5-aminolevulinic acid is more preferably 1: 1.

Further, the cellulose derivative accounts for, parts by mass, 0.5-3 parts, for example, 0.5 parts, 1 part, 1.5 parts, 2 parts, 2.5 parts or 3 parts.

Further, the cellulose derivative preferably accounts for 0.5-2.5 parts.

Biomass resources are the main renewable carbon source on the earth, and cellulose, hemicellulose, lignin, chitin, and the like all belong to biomass energy sources. Among them, cellulose has the largest production and is the first largest renewable resource on the earth. Conversion of cellulose can produce platform compounds such as 5-hydroxymethylfurfural, 2,5-furandicarboxylic acid, levulinic acid, and 5-aminolevulinic acid, which are useful in polyester, polyamide, metal organic backbone materials, drug synthesis, plasticizers, and the like. The cellulose derivative in the cleaning solution of the present disclosure can effectively remove CuO formed by Cu oxidation caused by the polishing solution.

Further, the chitin derivative is one or more of chitosan oligosaccharide, carboxymethyl chitosan, N-acetyl glucose, glucosamine, and carboxymethyl glucosamine.

Further, the chitin derivative includes a component A and a component B. The component A is a chitosan oligosaccharide and/or a carboxymethyl chitosan. The B component is one or more of N-acetylglucose, glucosamine and carboxymethyl glucosamine. The use of both the component A and the component B leads to better reoxidation inhibition and corrosion inhibition, because small molecule chitin derivative can be embedded in chitosan oligosaccharide and carboxymethyl chitosan oligosaccharide having a higher molecular weight, thereby a dense protective film may be formed on the Cu surface.

Further, a mass ratio of the component A to the component B is 3:1-1:3.

Further, the mass ratio of the component A to the component B is preferably 2:1-1:2.

Further, the mass ratio of the component A to the component B is more preferably 2: 1.

Further, a polymerization degree of the chitosan oligosaccharide is an integer of from 2 to 20.

Further, the polymerization degree of the chitosan oligosaccharide is preferably from 4 to 8.

Further, a molecular weight of the carboxymethyl chitosan is 1,000-10,000, for example, 1,000, 2,000, 3,000, 4,000, 5,000, 6,000, 7,000, 8,000, 9,000 or 10,000.

Further, the molecular weight of the carboxymethyl chitosan is preferably 3,000-5,000.

Further, the chitin derivative accounts for, parts by mass, 0.5-2 parts, for example, 0.5 parts, 1 part, 1.5 parts, or 2 parts.

Further, the chitin derivative accounts for preferably 0.5-1.5 parts.

Chitin is a nitrogen-containing natural organic polymer with the largest amount except for protein in nature, and can be extracted from shells of shrimps, crabs, and the like. The production of chitin is second to that of cellulose. Chitin is a binary linear copolymer which is formed by 2-acetamido-2-deoxy-β-D-glucopyranose or 2-amino-2-deoxy-β-D-glucopyranose. Chitin can be converted to produce a variety of products such as chitosan, chitosan oligosaccharide, carboxymethyl chitosan, N-acetyl glucose, glucosamine, carboxymethyl glucosamine, and the like. Chitin and its derivatives have a wide range of uses, such as use in industries such as biomedical materials, health care products, cosmetics and food industries.

The cellulose derivative in the cleaning solution according to the present disclosure removes CuO, meanwhile the chitin derivative generates a monomolecular adsorbent layer on the Cu₂O surface left after the CuO film is removed, thereby protecting the underlying Cu. The chitin derivative has an antioxidant effect, which inhibits further oxidation of Cu₂O to CuO in the waiting time, expanding the process window, avoiding the reduction of V_{bd}, and improving the reliability of the device.

The post-chemical mechanical polishing cleaning solution of semiconductor chips according to the present disclosure does not require the addition of other chelating agents, corrosion inhibitors and surfactants, because the cellulose derivative and the chitin derivative include a polyhydroxy substance or an organic carboxylic acid, so that the effect of chelating the metal ions, inhibiting corrosion of the metal, and reducing surface tension can be realized. Therefore, the post-chemical mechanical polishing cleaning solution of semiconductor chips according to the present disclosure is natural and green, and conforms to the concept of "green manufacturing".

Further, the ultrapure water is deionized water having a resistance of at least 18 MΩ at 25°C.

Further, the ultrapure water accounts for, parts by mass, 70-95 parts, for example, 70 parts, 75 parts, 80 parts, 85 parts, 90 parts or 95 parts.

Further, the ultrapure water preferably accounts for 80-90 parts.

The above-mentioned materials are well-known and commonly used materials and are commercially available.

The present disclosure further provides a method for preparing a post-chemical mechanical polishing cleaning solution of semiconductor chips, including:

adding a strong base and a weak base to ultrapure water and mixing uniformly to obtain a mixture; adding a cellulose derivative and a chitin derivative into the mixture; and mixing uniformly to prepare the post-chemical mechanical polishing cleaning solution of semiconductor chips.

Further, filtering is carried out after uniform mixing. The filtering is performed preferably with a 0.2 µm filter bag. Other forms of filtering method may be selected by those skilled in the art and will not be described in detail herein.

Further, the preparation method is carried out at room temperature.

Further, the stirring time and the stirring speed during mixing are not particularly limited, as long as the system can be uniformly stirred.

The present disclosure further provides a use of a post-chemical mechanical polishing cleaning solution of semiconductor chips in the field of cleaning semiconductor chips. The post-chemical mechanical polishing cleaning solution is particularly suitable for cleaning contaminants on a post-CMP Cu wafer. The cleaning solution can effectively remove organic and inorganic particulate contaminants generated after CMP for copper, and has excellent removal effect especially for CuO on the surface, and the reoxidation of the Cu surface is suppressed in a subsequent waiting time.

Further, the method for cleaning a post-CMP Cu wafer with a post-chemical mechanical polishing cleaning solution of semiconductor chips includes the steps of immersing the post-CMP Cu wafer in the post-chemical mechanical polishing cleaning solution of semiconductor chips at room temperature, or spraying the post-chemical mechanical polishing cleaning solution of semiconductor chips onto the post-CMP Cu wafer, rinsing with ultrapure water after the immersion or the spraying, and drying with high-purity nitrogen to finish the cleaning of the post-CMP Cu wafer.

Further, the immersion or the spraying is performed for 2 to 5 minutes, for example, for 2 minutes, 3 minutes, 4 minutes or 5 minutes.

Further, the ultrapure water is deionized water having a resistance of at least 18 MΩ at 25°C.

The present disclosure relates to a post-chemical mechanical polishing cleaning solution of semiconductor chips, a preparation method and use thereof, and has the following advantages compared with the prior art.

1). The cellulose derivative in the cleaning solution of the present disclosure can effectively remove CuO formed by oxidation of Cu caused by the polishing solution, and the chitin derivative generates a monomolecular adsorbent layer on the Cu₂O surface left after the CuO film is removed, thereby protecting the underlying Cu. In addition, the chitin derivative has an antioxidation effect, thereby inhibiting further oxidation of Cu₂O to CuO within the waiting time, expanding the process window, avoiding reduction of V_{bd}, and improving reliability of the device.

2). The cellulose derivative in the cleaning solution of the present disclosure selects, for example, both 2,5-furandicarboxylic acid and 5-aminolevulinic acid, so that the corrosion by the carboxyl group and the chelation by the amino group are used together to remove CuO more quickly. The use of both the component A (chitin derivative chitosan oligosaccharide and/or carboxymethyl chitosan oligosaccharide) and the component B (one or more of N-acetyl glucose, glucosamine and carboxymethyl glucosamine) leads to better reoxidation inhibition and corrosion inhibition, because small chitin derivative molecules can be embedded in chitosan oligosaccharide and carboxymethyl chitosan oligosaccharide having a higher molecular weight, thereby a dense protective film may be formed on the Cu surface.

3). The cleaning solution of the present disclosure provides an alkaline environment, which can improve electrostatic repulsion of particulate contaminants and substrates, can completely remove contaminations from abrasive particles and metal particles, and prevent re-adsorption of particles.

4). The cleaning solution of the present disclosure has simple composition and is green and environmentally friendly. It adopts renewable biomass derivatives as additives, avoiding additives from petroleum derivatives, and plays a role of metal ion chelation, metal corrosion inhibition, and surface tension adjustment.

5). The cleaning solution of the present disclosure does not require the addition of other chelating agents, corrosion inhibitors and surfactants, because the cellulose derivative and the chitin derivative include polyhydroxy substances or organic carboxylic acids, so that the effect of chelating the metal ions, inhibiting corrosion of the metal, and reducing surface tension can be realized. Therefore, the cleaning solution according to the present disclosure is natural and green, and conforms to the concept of "green manufacturing".

Therefore, the post-chemical mechanical polishing cleaning solution of the present disclosure has a good application prospect and a large-scale industrial promotion potential in the field of semiconductor chip cleaning.

### BRIEF DESCRIPTION OF THE DRAWINGS

FIG. 1 is a scanning electron microscope (SEM) image of an uncleaned post-CMP Cu wafer at a magnification of 10,000X.
FIG. 2 is a scanning electron microscope image of a post-CMP Cu wafer that is cleaned with the cleaning solution prepared in Example 1, at a magnification of 10,000X.
FIG. 3 is an X-ray photoelectron spectrum of a Cu 2p orbit of a post-CMP Cu wafer.
FIG. 4 is an X-ray photoelectron spectrum of a Cu 2p orbit of a post-CMP Cu wafer that is cleaned with the cleaning solution prepared in Example 1.
FIG. 5 is an X-ray photoelectron spectrogram of a Cu 2p orbit of a post-CMP Cu wafer that is cleaned with a cleaning solution prepared in Comparative Example 1.

### DETAILED DESCRIPTION

The cleaning solutions of the present disclosure will be described below in conjunction with the following examples.

### Examples 1-16

Post-chemical mechanical polishing cleaning solutions of semiconductor chips according to the present disclosure are illustrated in Examples 1-16. Various components and mass parts thereof in the cleaning solutions are shown in Table 1. A method for preparing the cleaning solutions includes the following steps: adding a strong base and a weak base to ultrapure water at room temperature, and mixing uniformly to obtain a mixture; then adding a cellulose derivative and a chitin derivative into the mixture and mixing uniformly; filtering the resulting mixture with a 0.2 µm filter bag to prepare the post-chemical mechanical polishing cleaning solutions of semiconductor chips.

**Table 1. Components and mass parts of the post-chemical mechanical polishing cleaning solutions of semiconductor chips in Examples 1-16**

| Ex am ple | Strong base/Parts | Weak base/Parts | Cellulose derivative/Parts | Chitin derivative/ Parts | Ultrapure water/Parts |
|---|---|---|---|---|---|
| 1 | Tris(2-hydroxyethyl)-methyl ammonium hydroxide 10 parts | N-methyl ethanolamine 15 parts | 2,5-furandicarboxylic acid 1 part | Carboxymethyl chitosan oligosaccharide having a molecular weight of 3,000 1 part | 85 parts |
| | | | 5-aminolevulinic acid 1 part | N-acetyl glucose 0.5 parts | |
| 2 | (2-Hydroxyethyl) trimethyl ammonium hydroxide 20 parts | Triethanolamine 30 parts | 2,5-furandicarboxylic acid 0.5 parts | Carboxymethyl chitosan oligosaccharide having a molecular weight of 5,000 1.5 parts | 95 parts |
| | | | 5-aminolevulinic acid 1.5 parts | Glucosamine 0.5 parts | |
| 3 | Tetramethyl ammonium hydroxide 15 parts | Diglycolamine 25 parts | 2,5-furandicarboxylic acid 1 part | Carboxymethyl chitosan oligosaccharide having a molecular weight of 10,000 0.5 parts | 90 parts |
| | | | 5-aminolevulinic acid 0.5 parts | Carboxymethyl glucosamine 0.5 parts | |
| 4 | Tetraethyl ammonium hydroxide 10 parts | N,N-dimethyl ethanolamine 20 parts | 2,5-furandicarboxylic acid 0.5 parts | Chitosan oligosaccharide in a polymerization degree of 4 0.5 parts | 85 parts |
| | | | 5-aminolevulinic acid 2 parts | N-acetyl glucose 0.5 parts | |
| 5 | Tetrapropyl ammonium hydroxide 5 parts | N-ethyl ethanolamine 15 parts | Levulinic acid 1 part | Chitosan oligosaccharide in a polymerization degree of 6 1 part | 80 parts |
| | | | 5-aminolevulinic acid 1 part | Glucosamine 0.5 parts | |
| 6 | Tetrabutyl ammonium hydroxide 20 parts | N-phenyl ethanolamine 10 parts | 5-aminolevulinic acid 3 parts | Chitosan oligosaccharide in a polymerization degree of 8 0.5 parts | 75 parts |
| | | | | Carboxymethyl glucosamine 1 part | |
| 7 | Dimethyl diethyl ammonium hydroxide 15 parts | Monoethanolam ine 5 parts | 2,5-furandicarboxylic acid 2 parts | Chitosan oligosaccharide in a polymerization degree of 20 0.5 parts | 70 parts |
| | | | Levulinic acid 0.5 parts | | |
| 8 | Potassium hydroxide 10 parts | Diethanolamine 15 parts | Levulinic acid 2 parts | Carboxymethyl chitosan oligosaccharide having a molecular weight of 1,000 1 part | 90 parts |
| | | N-phenyl ethanolamine 15 parts | | | |
| 9 | Cesium hydroxide 5 parts | N-ethyl ethanolamine 25 parts | 2,5-furandicarboxylic acid 0.5 parts | N-acetyl glucose 1.5 parts | 85 parts |
| | | | Levulinic acid 1 part | | |
| 10 | Tetrabutyl ammonium hydroxide 10 parts | Monoethanolam ine 20 parts | 5-aminolevulinic acid 1 part | Carboxymethyl chitosan oligosaccharide having a molecular weight of 1,000 0.5 parts | 80 parts |
| | Potassium hydroxide 10 parts | | | Glucosamine 1.5 parts | |
| 11 | Cesium hydroxide 5 parts | Triethanolamine 15 parts | Levulinic acid 0.5 parts | Carboxymethyl glucosamine 1 part | 75 parts |
| | Tris(2-hydroxyethyl)-methyl ammonium hydroxide 5 parts | | | | |
| 12 | (2-Hydroxyethyl) trimethyl ammonium hydroxide 2.5 parts | Diglycolamine 5 parts | 2,5-furandicarboxylic acid 2.5 parts | Chitosan oligosaccharide in a polymerization degree of 2 2 parts | 70 parts |
| | Tetramethyl ammonium hydroxide 2.5 parts | | | | |
| 13 | Tris(2-hydroxyethyl)-methyl ammonium hydroxide 10 parts | N-methyl ethanolamine 15 parts | 5-aminolevulinic acid 1 part | Carboxymethyl chitosan oligosaccharide having a molecular weight of 3,000 1 part | 85 parts |
| | | | | N-acetyl glucose 0.5 parts | |
| 14 | Tris(2-hydroxyethyl)-methyl ammonium hydroxide 10 parts | N-methyl ethanolamine 15 parts | 2,5-furandicarboxylic acid 1 part | Carboxymethyl chitosan oligosaccharide having a molecular weight of 3,000 1 part | 85 parts |
| | | | | N-acetyl glucose 0.5 parts | |
| 15 | Tris(2-hydroxyethyl)-methyl ammonium hydroxide 10 parts | N-methyl ethanolamine 15 parts | 2,5-furandicarboxylic acid 1 part | - | 85 parts |
| | | | 5-aminolevulinic acid 1 part | N-acetyl glucose 0.5 parts | |
| 16 | Tris(2-hydroxyethyl)-methyl ammonium hydroxide 10 parts | N-methyl ethanolamine 15 parts | 2,5-furandicarboxylic acid 1 part | Carboxymethyl chitosan oligosaccharide having a molecular weight of 3,000 1 part | 85 parts |
| | | | 5-aminolevulinic acid 1 part | - | |

### Comparative Examples 1-4

Components and mass parts of cleaning solutions according to Comparative Examples 1-4 are shown in Table 2, and the method for preparing the cleaning solutions according to Comparative Examples 1 to 4 are the same as that in Example 1.

**Table 2. Components and mass parts of the cleaning solutions in Comparative Examples 1-4**

| Comparative Example | Strong base/Parts | Weak base/Parts | Cellulose derivative/Parts | Chitin derivative/Parts | Ultrap ure water/ Parts |
|---|---|---|---|---|---|
| 1 | Tris(2-hydroxyethyl)-methyl ammonium hydroxide 10 parts | N-methyl ethanolamine 15 parts | - | Carboxymethyl chitosan oligosaccharide having a molecular weight of 3,000 1 part | 85 parts |
| | | | | N-acetyl glucose 0.5 parts | |
| 2 | Tris(2-hydroxyethyl)-methyl ammonium hydroxide 10 parts | N-methyl ethanolamine 15 parts | 2,5-furandicarboxylic acid 1 part | - | 85 parts |
| | | | 5-aminolevulinic acid 1 part | - | |
| 3 | Tris(2-hydroxyethyl)-methyl ammonium hydroxide 10 parts | N-methyl ethanolamine 15 parts | 2,5-furandicarboxylic acid 0.1 part | Carboxymethyl chitosan oligosaccharide having a molecular weight of 3,000 1 part | 85 parts |
| | | | 5-aminolevulinic acid 0.2 parts | N-acetyl glucose 0.5 parts | |
| 4 | Tris(2-hydroxyethyl)-methyl ammonium hydroxide 10 parts | N-methyl ethanolamine 15 parts | 2,5-furandicarboxylic acid 1 part | Carboxymethyl chitosan oligosaccharide having a molecular weight of 3,000 0.1 part | 85 parts |
| | | | 5-aminolevulinic acid 1 part | N-acetyl glucose 0.2 parts | |

### Performance Tests

Various properties of the cleaning solutions according to the above examples or comparative examples were tested as follows.

### (1) Cleaning test of CuO

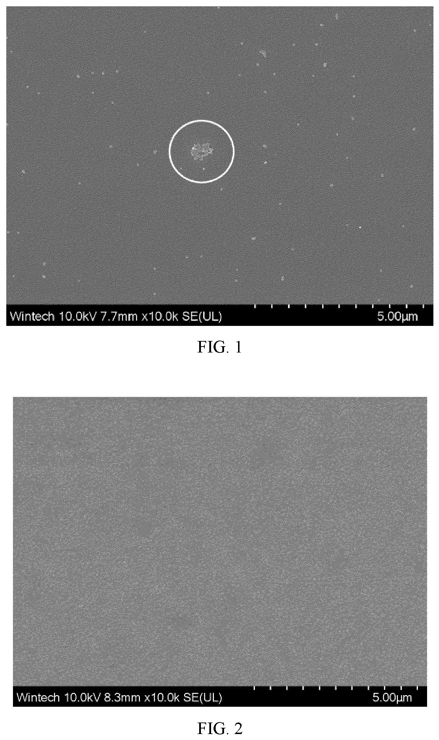

FIG. 1 is a scanning electron microscope (SEM) image of an uncleaned post-CMP Cu wafer at a magnification of 10,000X. It can be seen from FIG. 1, many nano-silicon oxide particles having an average particle size of about 50 nm and in a disperse or agglomerate state are present on the ground Cu wafer.

FIG. 2 is a scanning electron microscope image of a post-CMP Cu wafer that is cleaned with the cleaning solution prepared in Example 1, at a magnification of 10,000X. It can be seen from FIG. 2 that the Cu wafer treated with the cleaning solution in Example 1 is clean, and the nano-silicon oxide particles thereon are removed.

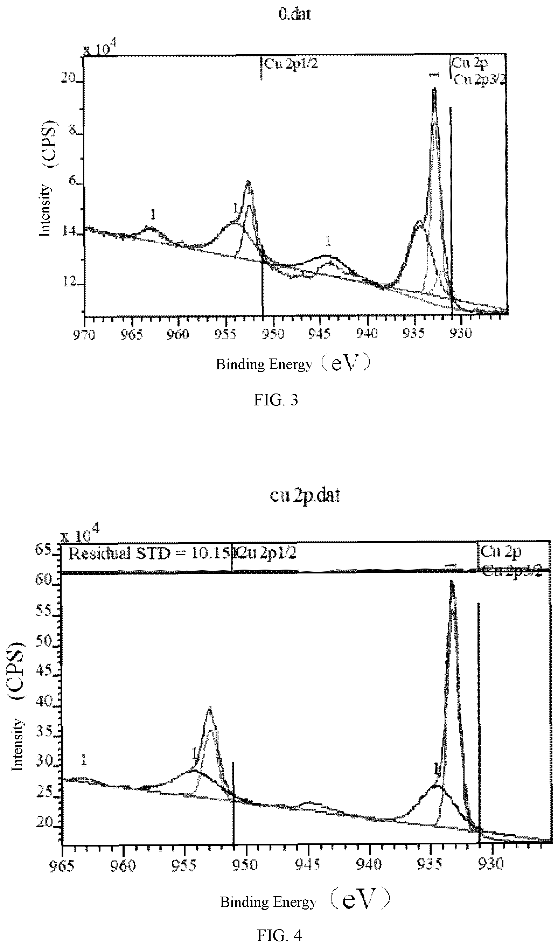

FIG. 3 is an X-ray photoelectron spectrum of a Cu 2p orbit of a post-CMP Cu wafer . It can be seen from FIG. 3 that the post-CMP Cu surface is oxidized to form two oxides, CuO and Cu₂O. In the X-ray photoelectron spectrum, the binding energy at 932.695 eV represents Cu (0), the binding energy at 934.379 eV represents Cu (I), and the binding energy at 931.879 eV represents Cu (II).

FIG. 4 is an X-ray photoelectron spectrum of a Cu 2p orbit of a post-CMP Cu wafer that is cleaned with the cleaning solution prepared in Example 1. It can be seen from FIG. 4 that CuO on the Cu wafer can be removed after the Cu wafer is cleaned with the cleaning solution in Example 1. In the above X-ray photoelectron spectrum, the binding energy at 932.122 eV represents Cu (0), and the binding energy at 934.443 eV represents Cu (I).

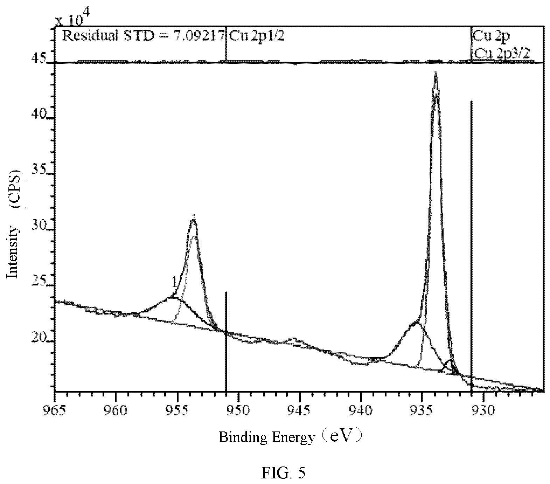

FIG. 5 is an X-ray photoelectron spectrum of a Cu 2p orbit of a post-CMP Cu wafer that is cleaned with a cleaning solution prepared in Comparative Example 1. It can be seen from

FIG. 5 that CuO on the Cu wafer cannot be completely removed after the Cu wafer is cleaned with the cleaning solution in Comparative Example 1. In the above X-ray photoelectron spectrum, the binding energy at 933.9 eV represents Cu (0), the binding energy at 935.5 eV represents Cu (I), and the binding energy at 932.8 eV represents Cu (II).

XPS spectra are integrated respectively to obtain the percentages of different valence states of Cu, as shown in Table 3.

**Table 3. Percentage of different valence states of Cu**

| Cu wafer | Cu (0) | Cu (I) | Cu (II) |
|---|---|---|---|
| Uncleaned | 43.96 | 46.13 | 9.91 |
| Cleaned with the cleaning solution in Example 1 | 63.67 | 36.33 | 0 |
| Cleaned with the cleaning solution in Example 2 | 64.92 | 35.08 | 0 |
| Cleaned with the cleaning solution in Example 3 | 64.99 | 35.01 | 0 |
| Cleaned with the cleaning solution in Example 4 | 62.73 | 37.27 | 0 |
| Cleaned with cleaning solution in Example 5 | 63.87 | 36.13 | 0 |
| Cleaned with cleaning solution in Example 6 | 64.22 | 35.78 | 0 |
| Cleaned with cleaning solution in Example 7 | 63.98 | 36.02 | 0 |
| Cleaned with cleaning solution in Example 8 | 64.09 | 35.91 | 0 |
| Cleaned with cleaning solution in Example 9 | 62.98 | 37.02 | 0 |
| Cleaned with cleaning solution in Example 10 | 62.67 | 37.33 | 0 |
| Cleaned with cleaning solution in Example 11 | 64.01 | 35.99 | 0 |
| Cleaned with cleaning solution in Example 12 | 64.62 | 35.38 | 0 |
| Cleaned with cleaning solution in Example 13 | 64.12 | 35.88 | 0 |
| Cleaned with cleaning solution in Example 14 | 64.20 | 35.80 | 0 |
| Cleaned with cleaning solution in Example 15 | 64.21 | 35.79 | 0 |
| Cleaned with cleaning solution in Example 16 | 63.17 | 36.83 | 0 |
| Cleaned with the cleaning solution in Comparative Example 1 | 69.79 | 25.83 | 4.38 |
| Cleaned with the cleaning solution in Comparative Example 2 | 63.82 | 36.18 | 0 |
| Cleaned with the cleaning solution in Comparative Example 3 | 65.43 | 33.34 | 1.23 |
| Cleaned with the cleaning solution in Comparative Example 4 | 63.78 | 36.22 | 0 |

As can be seen from Table 3, the cleaning solution in Comparative Example 1 does not include the cellulose derivative, and it is unable to remove CuO. The cleaning solutions in Examples 1-16 include cellulose derivatives, so CuO can be completely removed. The cleaning solution of Comparative Example 3 also fails to achieve a good removal of CuO due to the low amount of the cellulose derivative. This indicates that the cellulose derivatives are useful for CuO removal. In Comparative Examples 2 and 4, cellulose derivatives are added in the cleaning solutions, without or with the chitin derivatives in a low amount, so that CuO is completely removed from the surface, indicating that the chitin derivatives are non-essential for CuO removal, but the cellulose derivatives are important substances for CuO removal.

### (2) Re-oxidation test of Cu surface during the waiting time

It is necessary to consider, in addition to CuO to be removed from the Cu surface, whether another CuO may be generated on the Cu surface by re-oxidation during the waiting time.

Table 4 shows the percentages of different valence states of Cu measured using XPS spectra for the post-CMP Cu wafers that are treated with the solutions in Examples 1-16 and Comparative Examples 1-4, followed by exposuring to an atmosphere environment at 25°C.

**Table 4. Percentages of different valence states of Cu under an atmospheric environment at 25°C**

| Cu wafer | Holding period | Cu (0) | Cu (I) | Cu (II) |
|---|---|---|---|---|
| Uncleaned | 4h | 42.12 | 45.12 | 12.76 |
| | 8h | 41.78 | 43.78 | 14.44 |
| Cleaned with the cleaning solution in Example 1 | 4h | 62.98 | 36.68 | 0.34 |
| | 8h | 63.73 | 35.76 | 0.51 |
| Cleaned with the cleaning solution in Example 2 | 4h | 65.13 | 34.59 | 0.28 |
| | 8h | 64.75 | 34.78 | 0.47 |
| Cleaned with the cleaning solution in Example 3 | 4h | 62.97 | 36.85 | 0.18 |
| | 8h | 63.56 | 36.01 | 0.43 |
| Cleaned with the cleaning solution in Example 4 | 4h | 63.17 | 36.58 | 0.25 |
| | 8h | 64.01 | 35.60 | 0.39 |
| Cleaned with the cleaning solution in Example 5 | 4h | 62.18 | 37.50 | 0.32 |
| | 8h | 63.77 | 35.71 | 0.52 |
| Cleaned with the cleaning solution in Example 6 | 4h | 63.45 | 36.26 | 0.29 |
| | 8h | 64.67 | 34.80 | 0.53 |
| Cleaned with the cleaning solution in Example 7 | 4h | 64.03 | 35.79 | 0.18 |
| | 8h | 62.19 | 37.44 | 0.37 |
| Cleaned with the cleaning solution in Example 8 | 4h | 62.73 | 37.02 | 0.25 |
| | 8h | 64.01 | 35.45 | 0.54 |
| Cleaned with the cleaning solution in Example 9 | 4h | 63.71 | 36.09 | 0.20 |
| | 8h | 62.94 | 36.58 | 0.48 |
| Cleaned with the cleaning solution in Example 10 | 4h | 63.19 | 36.53 | 0.28 |
| | 8h | 64.22 | 35.33 | 0.45 |
| Cleaned with the cleaning solution in Example 11 | 4h | 62.87 | 36.92 | 0.21 |
| | 8h | 64.77 | 34.68 | 0.55 |
| Cleaned with the cleaning solution in Example 12 | 4h | 64.21 | 35.45 | 0.34 |
| | 8h | 63.38 | 36.08 | 0.54 |
| Cleaned with the cleaning solution in Example 13 | 4h | 64.03 | 35.77 | 0.20 |
| | 8h | 64.97 | 34.60 | 0.43 |
| Cleaned with the cleaning solution in Example 14 | 4h | 64.21 | 35.56 | 0.23 |
| | 8h | 63.86 | 35.70 | 0.44 |
| Cleaned with the cleaning solution in Example 15 | 4h | 64.04 | 35.79 | 0.17 |
| | 8h | 63.5 | 36.12 | 0.38 |
| Cleaned with the cleaning solution in Example 16 | 4h | 62.79 | 36.92 | 0.29 |
| | 8h | 62.52 | 36.98 | 0.50 |
| Cleaned with the cleaning solution in Comparative Example 1 | 4h | 69.22 | 26.26 | 4.52 |
| | 8h | 68.32 | 26.88 | 4.80 |
| Cleaned with the cleaning solution in Comparative Example 2 | 4h | 62.18 | 35.20 | 2.62 |
| | 8h | 61.49 | 34.33 | 4.18 |
| Cleaned with the cleaning solution in Comparative Example 3 | 4h | 64.97 | 33.52 | 1.51 |
| | 8h | 64.59 | 33.79 | 1.62 |
| Cleaned with the cleaning solution in Comparative Example 4 | 4h | 61.66 | 36.52 | 1.82 |
| | 8h | 60.17 | 36.38 | 3.45 |

As can be seen from Table 4, CuO on the uncleaned Cu surface or on the Cu surface cleaned with the cleaning solution in Comparative Example 2 that does not include the chitin derivative is increased by 2.5% or more over the waiting time of the initial 4 h. CuO on the Cu surfaces that are cleaned with the cleaning solutions in Examples 1-16 and the cleaning solutions in Comparative Example 1 that includes the chitin derivative (without cellulose derivatives) is increased by 0.35% or less over the waiting time of the initial 4 h. The cleaning solution in Comparative Example 4 includes a small amount of the chitin derivative and can play a certain role on the Cu surface, so that regeneration rate of CuO on the Cu surface is between that in Examples 1-16 and Comparative Example 2. It can be concluded that the addition of the chitin derivatives can inhibit the re-oxidation of the Cu surface. Therefore, the cleaning solutions in Examples 1-16 can prevent the reduction of V_{bd} and improve the reliability of the device.

### (3) Corrosion rate test to substrate

The corrosion to the substrate of the cleaning solutions in Examples 1-16 and Comparative Examples 1-4 is evaluated, and results are shown in Table 5.

**Table 5. Corrosion to substrate of the cleaning solutions**

| Corrosion Rate (Å/min) | Cu | Co | Ta | TaN | SiO₂ |
|---|---|---|---|---|---|
| Example 1 | 0.08 | 0.12 | 0.18 | 0.15 | 0.19 |
| Example 2 | 0.15 | 0.27 | 0.17 | 0.24 | 0.38 |
| Example 3 | 0.10 | 0.30 | 0.17 | 0.22 | 0.40 |
| Example 4 | 0.11 | 0.21 | 0.14 | 0.26 | 0.38 |
| Example 5 | 0.09 | 0.33 | 0.21 | 0.30 | 0.22 |
| Example 6 | 0.20 | 0.21 | 0.19 | 0.17 | 0.31 |
| Example 7 | 0.18 | 019 | 0.25 | 0.20 | 0.22 |
| Example 8 | 0.17 | 0.25 | 0.28 | 0.23 | 0.29 |
| Example 9 | 0.12 | 0.22 | 0.19 | 0.21 | 0.45 |
| Example 10 | 0.15 | 0.18 | 0.17 | 0.22 | 0.15 |
| Example 11 | 0.22 | 0.26 | 0.27 | 0.20 | 0.34 |
| Example 12 | 0.25 | 0.31 | 0.28 | 0.27 | 0.31 |
| Example 13 | 0.12 | 0.33 | 0.16 | 0.20 | 0.35 |
| Example 14 | 0.17 | 0.28 | 0.20 | 0.19 | 0.21 |
| Example 15 | 0.20 | 0.32 | 0.15 | 0.11 | 0.25 |
| Example 16 | 0.19 | 0.28 | 0.17 | 0.10 | 0.38 |
| Comparative Example 1 | 0.09 | 0.31 | 0.18 | 0.24 | 0.41 |
| Comparative Example 2 | 5.88 | 10.12 | 6.55 | 7.56 | 2.69 |
| Comparative Example 3 | 0.26 | 0.35 | 0.19 | 0.15 | 0.51 |
| Comparative Example 4 | 2.84 | 2.38 | 3.01 | 2.51 | 1.11 |

As can be seen from Table 5, the cleaning solutions in Examples 1-16 and Comparative Example 1 in which the chitin derivatives are included have low corrosion rates to both metals and non-metals. The cleaning solutions in Comparative Example 2 without and Comparative Example 4 with a small amount of chitin derivatives have higher corrosion rates to the substrates, indicating that the chitin derivatives have a good inhibition effect on the corrosion of the substrate, possibly due to the polyhydroxyl structure thereof. The chitin derivatives contain -OH and -NH₂, which are electron-rich groups and can be adsorbed on the surface of the metal substrate having empty orbits, thereby exerting an inhibition effect on the corrosion of the substrate.

The methods for testing performances are described as follows:
1. Method for cleaning post-CMP Cu wafer:
   The polished Cu wafer was cut into square samples of 4*4 cm², and then the cut Cu wafer samples were placed in the cleaning solutions at 25°C for cleaning, with stirring at a rotating speed of 500 rpm for 5 minutes. The Cu wafer samples were taken out, rinsed with pure water for 1 minute, and purged with N₂.
2. Test for percentages of different valence states of Cu on the Cu wafer
   The polished Cu wafer was cut into square samples of 4*4 cm², and then the cut Cu wafer samples were placed in the cleaning solutions at 25°C for cleaning, with stirring at a rotating speed of 500 rpm for 5 minutes. The Cu wafer samples were taken out, rinsed with pure water for 1 minute, and purged with N₂. The surfaces of the Cu wafer samples before and after cleaning were tested using an X-ray photoelectron spectrometer. When the waiting time is needed, the wafer samples were placed in an atmospheric environment at 25°C for a certain time before testing with XPS.
3. Corrosion rate test to substrate:
   The corrosion to copper, cobalt, tantalum nitride, tantalum and silicon dioxide was quantitatively measured using a step meter. Specifically, Si substrates (size 4 × 4 cm²) coated with the above materials are immersed in the cleaning solutions at 25° C for 60 minutes. The step heights before and after immersing were measured using the step meter, and the corrosion rate (Å/min) was calculated to show the corrosion rate of the above-mentioned substrates by different cleaning solutions.

As mentioned above, the present disclosure provides examples of the use of a biomass-based derivative in the field of microelectronic cleaning. More specifically, there is provided a method for preparing a post-chemical mechanical polishing cleaning solution for copper, and a use of the cleaning solution and a method for cleaning a post-CMP Cu substrate using the cleaning solution. The cleaning solution provides an alkaline environment, improves the electrostatic repulsion of particulate contaminants to the substrate, completely removes contaminants of abrasive and metal particles, and preferably prevents re-adsorption of the particles. In addition, the cleaning solution has a simple composition and is environmentally friendly, in which renewable biomass derivatives are used as an additive, so as to avoid addition of any petroleum derivative additive, and function as the chelation of metal ions, metal corrosion inhibition, and surface tension adjustment. The cellulose derivative can effectively remove CuO formed by Cu oxidation caused by the polishing solution, and the chitin derivative forms a monomolecular adsorbent layer on the Cu₂O surface left after the CuO film is removed, thereby protecting the underlying Cu and preventing the oxidation of Cu. The chitin derivative has an antioxidant effect, thereby inhibiting the further oxidation of Cu₂O to CuO in the waiting time, expanding the process window, avoiding the reduction of V_{bd}, and improving the reliability of the device.

It is to be noted that the above-mentioned examples are merely illustrative of the technical solutions of the present disclosure and not restrictive thereof. Although the present disclosure has been described in detail with reference to the foregoing examples, it is to be understood by those of ordinary skill in the art that modifications may still be made to, or equivalent substitutions may be made to, some or all of the technical features described in the foregoing examples. These modifications or substitutions do not depart the essence of the corresponding technical solutions from the scope of the present disclosure.

## Claims

1. A post-chemical mechanical polishing cleaning solution of semiconductor chips, comprising, parts by mass:
5-20 parts of a strong base;
5-30 parts of a weak base;
0.5-3 parts of a cellulose derivative;
0.5-2 parts of a chitin derivative; and
70-95 parts of ultrapure water.

2. The post-chemical mechanical polishing cleaning solution according to claim 1, wherein the strong base is one or more of an organic strong base and an inorganic strong base.

3. The post-chemical mechanical polishing cleaning solution according to claim 1, wherein the weak base is an organic alcohol amine.

4. The post-chemical mechanical polishing cleaning solution according to claim 1, wherein the cellulose derivative is one or more of 2,5-furandicarboxylic acid, levulinic acid, and 5-aminolevulinic acid.

5. The post-chemical mechanical polishing cleaning solution according to claim 1, wherein the cellulose derivative is 2,5-furandicarboxylic acid and 5-aminolevulinic acid.

6. The post-chemical mechanical polishing cleaning solution according to claim 1, wherein the chitin derivative is one or more of chitosan oligosaccharide, carboxymethyl chitosan, N-acetyl glucose, glucosamine, and carboxymethyl glucosamine.

7. The post-chemical mechanical polishing cleaning solution according to claim 1, wherein the chitin derivative comprises a component A and a component B,
wherein the component A is one or more of a chitosan oligosaccharide and a carboxymethyl chitosan; and the B component is one or more of N-acetyl glucose, glucosamine, and carboxymethyl glucosamine.

8. A method for preparing a post-chemical mechanical polishing cleaning solution of semiconductor chips according to any one of claims 1 to 7, comprising:
adding a strong base and a weak base to ultrapure water, and mixing uniformly, to obtain a mixture; and
adding a cellulose derivative and a chitin derivative into the mixture, and mixing uniformly, to prepare the post-chemical mechanical polishing cleaning solution.

9. Use of a post-chemical mechanical polishing cleaning solution for copper in cleaning semiconductor chips.

10. The method according to claim 9, comprising:
immersing a post-CMP Cu wafer in the post-chemical mechanical polishing cleaning solution of semiconductor chips at room temperature, or spraying the post-chemical mechanical polishing cleaning solution of semiconductor chips onto the post-CMP Cu wafer;
rinsing the immersed Cu wafer or the sprayed Cu wafer with ultrapure water, and
drying with high-purity nitrogen to finish cleaning of the post-CMP Cu wafer.
